Europäisches Patentamt

European Patent Office

Office européen des brevets

(11) Numéro de publication: **0 166 633**
**A1**

# DEMANDE DE BREVET EUROPEEN

(21) Numéro de dépôt: 85400991.7

(51) Int. Cl.⁴: **H 01 L 23/48**

(22) Date de dépôt: 21.05.85

(30) Priorité: 25.05.84 FR 8408246

(43) Date de publication de la demande: 02.01.86
Bulletin 86/1

(84) Etats contractants désignés: **DE GB NL**

(71) Demandeur: THOMSON-CSF, 173, Boulevard
Haussmann, F-75379 Paris Cedex 08 (FR)

(72) Inventeur: Henry, Raymond, THOMSON-CSF
SCPI 173, bld Haussmann, F-75379 Paris Cedex 08 (FR)
Inventeur: Bessonneau, Guy, THOMSON-CSF
SCPI 173, bld Haussmann, F-75379 Paris Cedex 08 (FR)
Inventeur: Carnez, Bernard, THOMSON-CSF
SCPI 173, bld Haussmann, F-75379 Paris Cedex 08 (FR)

(74) Mandataire: Taboureau, James et al, THOMSON-CSF
SCPI 173, Bld Haussmann, F-75379 Paris Cedex 08 (FR)

(54) Structure de métallisation de reprise de contacts d'un dispositif semiconducteur, et dispositif doté d'une telle structure.

(57) L'invention concerne les dispositifs semi-conducteurs fonctionnant en hyperfréquences, notamment ceux qui travaillent au moins à 10 GHz, pour lesquels on ne sait pas réaliser de boîtiers d'encapsulation qui ne soient pas des cavités résonnantes.

Le dispositif semi-conducteur étant réalisé sur une pastille (1) reçoit des métallisations fines (8, 9, 10) en contact avec les régions du semi-conducteur. Ces métallisations fines sont toutes portées par une première face principale de la pastille (1). Selon l'invention, une première métallisation (8) reçoit une métallisation épaisse (11) qui permet la soudure « à l'envers » de la pastille (1) sur une embase métallique (7). La reprise de contact sur au moins une seconde métallisation (9) se fait au moyen d'un trou (4), métallisé sur sa paroi (12), réunissant la seconde métallisation (9) à une collerette métallique (13) portée par la seconde face principale de la pastille (1), du côté du substrat. Un cadre (15), en métallisation épaisse, entoure les métallisations (8, 9, 10) et, par soudure sur l'embase métallique (7), assure l'auto-encapsulation de la pastille.

Application aux systèmes hyperfréquences.

# STRUCTURE DE METALLISATIONS DE REPRISE DE CONTACTS D'UN DISPOSITIF SEMICONDUCTEUR ET DISPOSITIF DOTE D'UNE TELLE STRUCTURE

La présente invention concerne une structure de métallisations de reprise de contacts sur une pastille semiconductrice en matériau semiconducteur, la structure des contacts étant prévue pour assurer l'auto encapsulation de la pastille semiconductrice lorsque celle-ci est soudée à l'envers sur une embase.

Pratiquement tous les dispositifs semiconducteurs sur matériau IV, III-V sont concernés par l'invention : transistors ou circuits intégrés dont la fréquence de fonctionnement est supérieure ou égale à 1 GHz, mais, afin d'en rendre l'exposé plus clair, l'invention sera expliquée en s'appuyant sur le cas d'un transistor à effet de champ sur arséniure de gallium, ce qui ne limite nullement la portée de l'invention.

L'utilisation de transistors a effet de champ sur Ga As se heurte à un certain nombre de dificultés.

Au niveau de la pastille, la partie active d'un transistor à effet de champ occupe une épaisseur d'environ 0,2 à 1 micron, pour une épaisseur de pastille de l'ordre de 50 microns. D'une part, on ne sait pas passiver la surface d'une pastille Ga As comme on sait glassiver la surface d'une pastille de silicium par exemple, et cependant il faut protéger la pastille de Ga As qui se détériore à l'air ambiant. D'autre part, les semiconducteurs sur Ga As ont le plus souvent une structure horizontale : la chaleur est produite sur une face, dans la couche active, sur un micron d'apaisseur, et évacuée par l'autre face à travers les 50 microns de la pastille, ce qui n'est pas la meilleure solution.

Au niveau de l'encapsulation, les micro-boîtiers se comportent en hyperfréquence comme des cavités résonantes. N'importe quel corps solide, travaillant à quelques gigahertz, rayonne de l'énergie : s'il est encapsulé dans un boîtier, il y a des phénomènes de réflexion à l'intérieur du boîtier, d'où interférence. Or, on sait actuellement réaliser des pastilles de transistors hyperfréquence qui travaillent bien au-delà de quelques GHz, mais on ne sait pas réaliser de boîtiers convenables pour encapsuler des pastilles fonctionnant au-delà de 10 GHz.

C'est pourquoi de nombreux dispositifs tels que des amplificateurs fonctionnant au-delà de 10 GHz sont actuellement réalisés avec des pastilles semiconductrices nues, sans boîtier, ou bien dans un boîtier sans couvercle pour ne pas former cavité résonante, ce qui revient au même.

Enfin, un transistor comporte au moins trois métallisations pour les trois régions qui assurent son fonctionnement : source, grille et drain. Dans le domaine des transistors hyperfréquences il est nécessaire d'interdigiter un grand nombre de petits transistors élémentaires, ce qui fait qu'un premier groupe de métallisations sont réunies par un bus métallique, un second groupe de métallisations sont réunies par un second bus métallique mais, étant donné qu'une surface a par définition deux dimensions, il se pose un problème pour réunir le troisième groupe de métallisations. Généralement ce troisième groupe de métallisations est réuni à un troisième bus métallique par l'intermédiaire de fils ou de rubans qui forment pont dans l'air. Il y a alors des croisements entre les interconnexions, ce qui amène des effets parasites de selfs et de capacités, sans oublier le fait que la surface de telles pastilles est fragile puisqu'elle comporte un grand nombre de fils formant pont dans l'air.

La structure des métallisations de reprise de contacts électriques selon l'invention permet d'assurer simultanément :

- l'évacuation de la chaleur dégagée au cours du fonctionnement par la face de la pastille sur laquelle prend naissance cette chaleur, car la pastille est soudée à l'envers sur son embase, selon le procédé dit "flip-chip",

- l'auto-encapsulation de la pastille semiconductrice lorsqu'elle est soudée sur son embase métallique formant radiateur, car l'une des métallisations, celle qui est soudée sur l'embase, comporte un cadre métallique assurant l'étanchéité du volume compris entre l'embase et la pastille. Cette auto-encapsulation assure la protection de la surface active de la pastille,

- la réduction maximale des longueurs de liaison entre les électrodes de la pastille semiconductrice et le circuit qui l'entoure, donc la réduction des selfs et capacités parasites.

Ces résultats sont obtenus grâce au partage des métallisations de contacts électriques entre les deux faces principales de la pastille. L'une des métallisations, de préférence celle qui est prise sur le contact qui chauffe le plus, est renforcée en épaisseur par exemple par voie électrolythique, ainsi qu'un cadre métallisé qui suit le périmètre du dispositif semiconducteur. Ce cadre peut faire partie intégrante de la métallisation de contacts électriques. Cette métallisation épaisse de reprise de contact est portée par une première face de la pastille ainsi que le cadre épais, ce qui exclut de pouvoir prendre d'autres contacts sur cette même face après que le cadre ait été soudé sur l'embase métallique. Les autres contacts électriques sont alors pris sur la seconde face de la pastille, par l'intermédiaire de trous pratiqués à travers l'épaisseur de la pastille, lesdits trous étant eux-mêmes métallisés.

Il n'y a donc plus entrecroisement de métallisations et de fils de prise de contact sur une seule face de la pastille, ce qui diminue les selfs, et les métallisations peuvent être disposées de façon à diminuer les capacités parasites. Enfin, la pastille étant auto-encapsulée, avec son embase, est protégée : c'est le substrat qui est exposé à l'air mais cela a moins d'importance que l'exposition de la face active.

De façon plus précise l'invention concerne une structure des métallisations de reprise de contacts d'un dispositif semiconducteur, fonctionnant en hyperfréquences et réalisé dans une pastille de matériau semiconducteur ayant deux faces principales, une première face principale portant au moins deux métallisations en couche mince de contacts avec le dispositif, et une seconde face principale du côté du substrat, cette structure de reprise de contacts étant caractérisée en ce que :

- la reprise de contact sur une première métallisation se fait au moyen d'une métallisation épaisse qui permet la soudure ou la thermocompression, selon la technologie dite "à l'envers", de la pastille sur une embase métallique formant radiateur,

- la reprise de contact sur au moins une seconde métallisation dans le cas d'une diode, et deux dans le cas d'un transistor, se fait au moyen d'un trou, métallisé sur sa paroi, ce trou, pratiqué à travers la pastille, réunissant électriquement la seconde métallisation à une collerette métallique portée par la seconde face principale de la pastille,

- un cadre, en métallisation épaisse, porté par la première face principale de la pastille et entourant complètement les métallisations de contacts, assure l'auto-encapsulation de la pastille par soudure "à l'envers" sur l'embase.

L'invention sera mieux comprise, et ses avantages ressortiront de la description qui suit d'un exemple d'application, cette description s'appuyant sur les figures jointes en annexes et qui représentent :

- figure 1 : vue en plan des métallisations de contacts électriques sur une pastille de transistor à effet de champ selon l'art connu ;

- figure 2 : vue en coupe des métallisations de contacts électriques sur une pastille de transistor à effet de champ dans laquelle un type de contact est pris par l'intermédiaire d'un trou ;

- figure 3 : vue en coupe des métallisations de contacts électriques sur une pastille de transistor à effet de champ dans laquelle un type de contact est pris par métallisation épaisse, selon l'art connu ;

- figure 4 : vue en coupe d'une pastille de transistor à effet de champ dans laquelle les contact sont pris grâce à la structure de reprise de contact sur les métallisations selon l'invention ;

- figure 5 : vue de trois quart dans l'espace d'une pastille de transistor à effet de champ mettant en évidence le cadre qui permet l'auto-encapsulation de la pastille dotée de la structure selon l'invention.

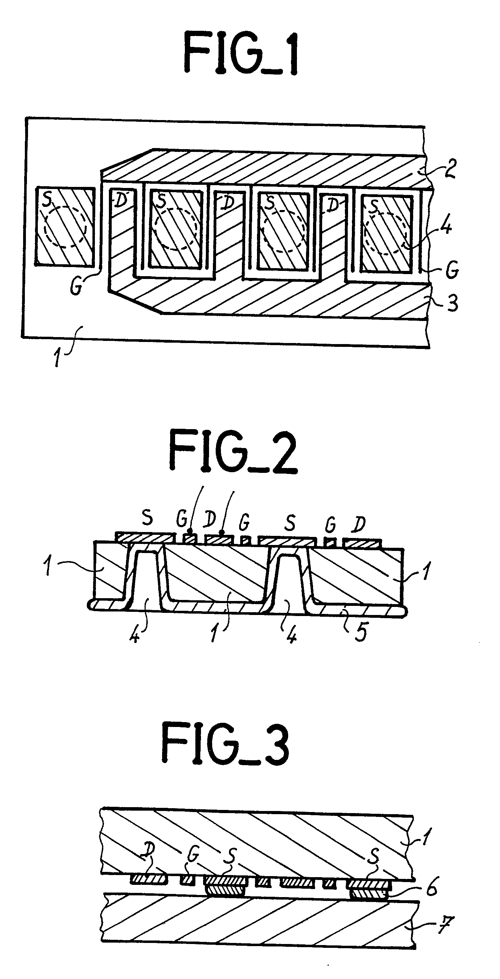

La figure 1 représente une vue en plan des métallisations de contacts électriques sur une pastille de transistor à effet de champ hyper fréquence. Tant que l'on ne considère qu'un transistor élémentaire comportant trois métallisations de source, de grille et de drain, il n'y a pas de problème pour reprendre les contacts sur la surface de la pastille au moyen de rubans métalliques déposés sur cette surface ou au moyen de fils. Par contre, puisqu'il s'agit de dispositifs semiconducteurs hyperfréquence, ceux-ci sont en raison même de leur fréquence de fonctionnement très petits et il est nécessaire pour obtenir une certaine puissance, d'en faire fonctionner un grand nombre en parallèle. Généralement les transistors hyperfréquences se présentent donc comme une ligne regroupant plusieurs petits transistors, et les structures sont très généralement interdigitées, c'est-à-dire qu'un premier type de métallisation est réuni à un bus métallique et un second type de métallisation réuni à un autre bus métallique. Sur la figure 1, les métallisations de grille sont réunies à un bus métallique 2 porté par la surface de la pastille 1, tandis que les métallisations de drain sont réunies à un bus métallique 3 porté par cette même surface de pastille 1. Le problème se pose donc pour sortir les troisièmes métallisations qui dans ce cas de figure sont les métallisations de source. D'autres groupements présenteraient le même problème : si par exemple ce sont les métallisations de source qui sont réunies par un bus, il faudra sortir les métallisations de grille. Différentes solutions sont connues. Dans une première solution, le troisième type de métallisation qu'on ne peut pas atteindre au moyen d'un bus métallique est connecté par des fils formant pont dans l'air, mais ces fils sont fragiles et présentent une certaine self. Dans une autre solution le bus de grille peut passer sous un bus de drain, ou de source, au moyen de ponts qui ont été formés par des techniques de masquage.

Une troisième solution de reprise de contacts électriques est celle qui est évoquée sur la figure 1 et illustrée sur la figure 2 : c'est celle des reprises de contacts par l'intermédiaire de trous 4 pratiqués à travers le substrat, selon une technique connue sous le nom de "via hole". Selon cette technique, des connexions de source sur la figure 1 sont prises sur la face cachée de la pastille par l'intermédiaire de métallisations déposées sur les parois de trous qui ont été formés chimiquement à travers l'épaisseur de la pastille a l'emplacement des métallisations des sources.

La figure 2 permet de mieux voir comment est réalisée cette technique.

Selon la vue en coupe de la figure 2, la face supérieure de la pastille 1 porte les métallisations de source, de grille et de drain qui correspondent sensiblement à la disposition des métallisations de la figure 1. Des contacts sont pris sur les grilles et sur les drains au moyen d'un bus, ces contacts étant symbolisés par deux fils thermo-soudés sur un plot grille et un plot drain. Au cours de la fabrication du dispositif semiconducteur, des trous 4 sont perforés chimiquement à travers le substrat ; l'attaque chimique vient buter contre les métallisations préalablement déposées, puis une métallisation 5 est déposée dans ces trous et sur la face arrière de la pastille.

Cette solution est fréquemment réalisée mais elle a, comme les autres solutions interdigitées, l'inconvénient que la chaleur dégagée par le transistor sur la face qui porte les métallisations de source, de grille et de drain est évacué par l'autre face.

C'est pourquoi une quatrième solution a été trouvée qui est illustrée en figure 3, selon laquelle on voit la vue en coupe d'une pastille soudée à l'envers sur une embase.

La pastille semiconductrice 1 porte sur une seule face une pluralité de métallisations de contact électrique avec les sources, grilles et drains. Parmi ces métallisations, celles d'un même type, présentant une surface suffisante, sont métallisées par apport d'un métal en couche épaisse 6, par voie électrolythique par exemple. En fait, ce sont soit presque toujours les métallisations de source car le fonctionnement normal est un fonctionnement source à la masse, soit plus rarement les métallisations de drain qui sont ainsi métallisées avec surcharge de métal. Lorsque la pastille a été rechargée en métal sur un seul type de métallisation de prise de contact, elle est soudée à l'envers sur une embase 7, qui est généralement une embase de cuivre doré qui sert de radiateur. Cette solution, connue sous l'appellation de "flip chip", a l'avantage de faciliter la dissipation de la chaleur puisque le radiateur est proche des zones du transistor dans lesquelles cette chaleur est crée. Mais il reste le problème de reprendre les contacts de grille et de drain ce qui se fait préalablement par soudure de fils ou rubans sur les plots, grille et drain.

En outre, si la solution de souder une pastille à l'envers est connue depuis longtemps, puisque cela se fait pour les circuits intégrés par l'intermédiaire de bossages plomb/étain sur les plots de connexions, cette solution n'apporte pas pour autant l'étanchéïté du volume compris entre la pastille de circuit intégré et l'embase, puisqu'il n'y a que des plots qui n'assurent aucune étanchéïté.

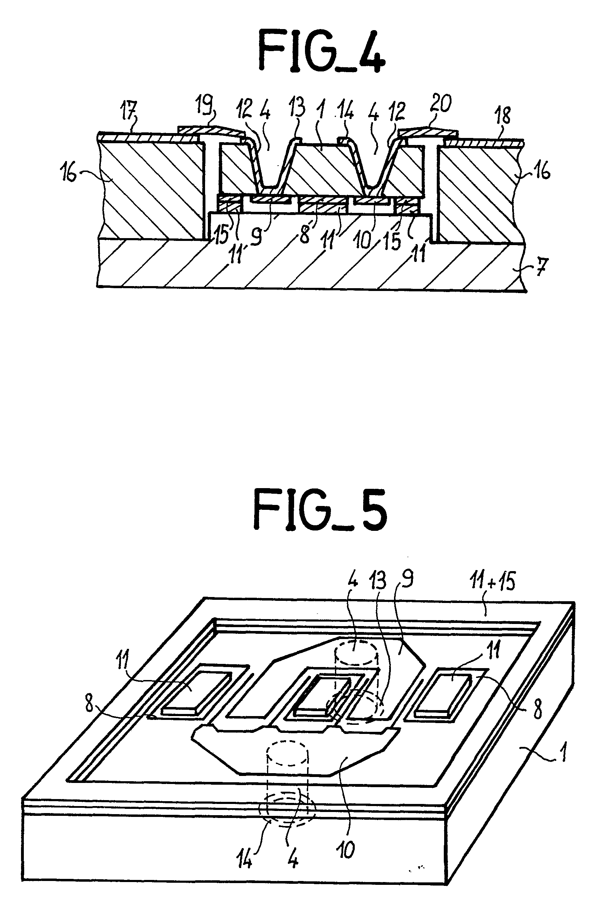

La figure 4 représente une vue en coupe d'une pastille de dispositif semiconducteur dans laquelle les contacts sont pris grâce à la structure selon l'invention.

La pastille 1 de matériau semiconducteur dans laquelle est réalisé le dispositif semiconducteur, c'est-à-dire un transistor dans l'exemple choisi, est ici représenté à l'inverse de sa représentation habituelle, c'est-a-dire que le substrat est en haut de la figure et la couche active est en bas (comme en figure 3).

Sur la surface de la pastille du transistor à effet de champ sont réalisées les métallisations de prises de contacts classiques, c'est-à-dire, par exemple une métallisation des plots source 8, une métallisation du bus de grille 9, une métallisation du bus de drain 10. Dans un premier temps, des trous 4 sont percés à travers l'épaisseur de la pastille puis métallisés par des métallisations 12, assurant un contact électrique avec les métallisations 9 et 10 correspondantes. Les métallisations des trous sont terminées, du côté du substrat de la pastille, par une colerette, respectivement 13 et 14, ces colerettes permettant une reprise de contact ultérieure.

Dans un second temps une métallisation, la métallisation de source dans le cas présent, mais de façon plus générale, l'ensemble des métallisations de source d'un transistor interdigité tel qu'il a été représenté en figure 1, sont chargées électrolythiquement par une sur-épaisseur de métal, ce qui donne un plot épais 11.

Par ailleurs au cours des opérations de métallisations des électrodes 8, 9 et 10, un cadre 15 a été métallisé : ce cadre a été obtenu par masquage. Lorsque la métallisation de source est chargée de métal de façon à donner un plot épais 11, le cadre 15 est lui aussi chargé de façon à obtenir une épaisseur totale qui soit égale à l'épaisseur du plot 8 + 11. Le cadre 15 a un dessin fermé et il suit approximativement le périmètre de la pastille semiconductrice 1. De façon plus générale le cadre 15 entoure le dispositif semiconducteur porté par la pastille 1, selon une configuration fermée.

La sur-épaisseur communiquée à un type de métallisation, la métallisation de source dans le cas présent, et au cadre qui entoure le dispositif semiconducteur, permet de retourner la pastille semiconductrice et de la souder selon la technique dite de soudure inverse sur une embase métallique 7. Cette embase métallique est en général en cuivre doré et elle sert de radiateur puisque la chaleur dégagée dans la couche active du transistor n'a plus à traverser pour être évacuée que l'épaisseur des plots épais 8+ 11.

La pastille étant soudée à l'envers, ou selon la technologie dite "flip chip", sur une embase à radiateur 7, une plaque d'un matériau isolant 16, percé d'un trou correspondant aux dimensions de la pastille du transistor, est fixée ou collée sur l'embase 7. Cette plaque de céramique supporte les pistes conductrices 17 et 18 correspondant aux électrodes du transistor dont les contacts sont pris par l'intermédiaire des trous métallisés. Il ne reste plus alors qu'à réunir une piste métallique telle que la piste 17 à la colerette 13 d'un trou métallisé par un ruban métallique 19 qui peut être très court, et de la même façon une autre piste telle que 18 à la colerette 14 d'un autre trou métallisé par un autre ruban métallique 20, également très court.

On voit donc l'avantage de cette structure : d'une part la chaleur dégagée dans la couche active du transistor est facilement dissipée vers l'embase métallique 7, et d'autre part, les liaisons électriques 19 et 20 sont très courtes, elles diminuent les selfs et les capacités. En outre, il est possible de diminuer la capacité parasite entre grille et drain en creusant chimiquement une cuvette entre les trous.

Enfin, il est extrêmement intéressant de constater que la partie sensible du transistor c'est-à-dire la surface de la pastille proche de la couche active se trouve auto-encapsulée dès lors qu'elle est soudée sur l'embase. Le volume compris entre la pastille 1, l'embase 7, et le cadre 15 est hermétiquement fermée, et l'atmosphère qui est emprisonnée au cours de la soudure peut facilement être une atmosphère contrôlée d'azote sec ou d'argon par exemple.

La figure 5 représente une vue de trois quart dans l'espace d'une pastille de transistor à effet de champ, mettant en évidence le cadre qui permet l'auto-encapsulation de la pastille. Cette figure correspond à la pastille de la figure 4, préparée au moyen de trous métallisés 4, avec des colerettes 13 et 14, et, portées par la face opposée de la pastille, les métallisations épaisses 8 et 15 + 11.

Le cadre 15 est séparé des métallisations d'accès ou de commande du transistor, dans le cas de figure représentée, mais ce cadre peut parfaitement, si le schéma électronique s'y prête, faire partie des métallisations de source.

L'invention a été exposée en s'appuyant sur le cas d'un transistor à effet de champ : toutefois il est bien évident que l'invention s'applique à tous dispositifs semiconducteurs pour lesquels il y a des difficultés à reprendre les contacts et à auto-encapsuler la pastille, si le dispositif semiconducteur comporte plus de deux électrodes et s'il travaille à très haute fréquence. Dans ces conditions, l'invention s'applique également à des circuits intégrés sur silicium ou sur matériau de la famille III-V, à une seule condition : c'est que les différents transistors utilisés dans le circuit intégré soient par exemple tous montés en drain commun, ou tous montés en source commune, ou tous montés en grille commune. Dans ce cas en effet, il n'y a pas d'inconvénients a ce que les métallisations épaisses 8 + 11 de plusieurs transistors d'un circuit intégré soient toutes électriquement court-circuitées par une soudure collective sur une embase 7.

Bien que l'exposé et les figures se rapportent a un transistor, la structure de reprise de contacts selon l'invention s'applique à une réalisation collective de transistors ou de circuits intégrés, en rondelle de silicium ou d'arséniure de gallium. La perforation des trous 4 et la soudure épaisse des cadres 15 et des métallisations 8 est beaucoup plus industrielle et aisée à l'échelle d'une rondelle qu'a l'échelle d'une pastille.

La structure de reprise de contact selon l'invention s'applique surtout aux dispositifs semiconducteurs travaillant en hyperfréquence c'est-à-dire essentiellement pour les systèmes de télécommunications et de radars. Les sous-ensembles nécessaires à la réalisation de ces matériels hyperfréquences, tels que des amplificateurs ou des oscillateurs sont alors réalisés sur des substrats du genre alumine ou oxyde de beryllium, avec des pastilles nues puisque grâce à la technologie de soudure inversée et à la structure des reprises de contacts selon l'invention les pastilles sont auto-encap-sulées : le problème des boîtiers formant cavité résonante est ainsi résolu par la suppression des boîtiers, sans préjudice de la protection des pastilles et en diminuant au maximum les selfs et capacités parasites puisque les liaisons entre les métallisations de la pastille et le circuit extérieur sont courtes.

REVENDICATIONS

1. Structure de métallisations de reprise de contacts d'un dispositif semiconducteur, fonctionnant en hyperfréquences et réalisé dans une pastille (1) de matériau semiconducteur ayant deux faces principales, une première face principale portant au moins deux métallisations (8, 9) en couche mince de contacts avec le dispositif, et une seconde face principale du côté du substrat, cette structure de reprise de contacts étant caractérisée en ce que :

- la reprise de contact sur une première métallisation (8) se fait au moyen d'une métallisation épaisse (11), qui permet la soudure, selon la technologie dite "à l'envers", de la pastille (1) sur une embase métallique (7) formant radiateur,

- la reprise de contact sur au moins une seconde métallisation (9) se fait au moyen d'un trou (4), métallisé sur sa paroi (12), ce trou, pratiqué à travers la pastille (1), réunissant électriquement la seconde métallisation (9) à une collerette métallique (13) portée par la seconde face principale de la pastille (1),

- un cadre (15), en métallisation épaisse, porté par la première face principale de la pastille et entourant complètement les métallisations de contacts (8, 9), assure l'auto-encapsulation de la pastille (1) par soudure "à l'envers" sur l'embase (7).

2. Structure des métallisations de reprise de contacs selon la revendication 1, caractérisée en ce que, lorsque le dispositif semiconducteur comporte une pluralité de types de contacts (8, 9, 10), et pour chaque type de contact une pluralité de métallisations en couche mince, la reprise de contact par métallisation épaisse (11) et soudure sur une embase (7) ne concerne qu'un seul type de contact, toutes les autres reprises de contacts sur les autres types de contacts se faisant au moyen de trous métallisés (4, 12) et de collerettes (13, 14) sur la seconde face de la pastille (1).

3. Structure des métallisations de reprise de contacts selon la revendication 1, caractérisée en ce que les liaisons électriques entre les collerettes (13, 14) et le circuit extérieur au dispositif semi- conducteur se font par des fils ou rubans métalliques (19, 20), courts, soudés sur les collerettes (13, 14) et sur les pistes conductrices (17, 18) du circuit extérieur.

4. Dispositif semiconducteur doté de la structure de reprise de contact, selon l'une quelconque des revendications précédentes caractérisé en ce qu'il est auto-encapsulé par soudure "à l'envers" de la pastille (1) sur une embase (7) métallique par un cadre (15).

5. Dispositif semiconducteur selon la revendication 4, caractérisé en ce que l'atmosphère comprise entre la pastille (1), l'embase (7) et le cadre épais (15) est une atmosphère sèche, contrôlée au cours de l'opération de soudure "à l'envers".

0166633

1/2

FIG_1

FIG_2

FIG_3

## FIG_4

## FIG_5

Office européen
des brevets

**RAPPORT DE RECHERCHE EUROPEENNE**

0166633
Numéro de la demande

EP  85 40 0991

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| A | EP-A-0 085 607  (THOMSON-CSF)<br>* Figure 7; abrégé * | 1 | H 01 L   23/48 |
| A | EP-A-0 081 396  (NASA) | 1 | |
| A | US-A-4 315 272  (J.L. VORHAUS)<br>* Figure 7 * | 1 | |
| A | GB-A-2 046 514  (RAYTHEON CO.)<br>* Figure 8; abrégé * | 1 | |
| | ----- | | |

DOMAINES TECHNIQUES RECHERCHES (Int. Cl.4)

H 01 L

Le présent rapport de recherche a été établi pour toutes les revendications

| Lieu de la recherche | Date d'achèvement de la recherche | Examinateur |
|---|---|---|
| LA HAYE | 30-09-1985 | IRVINE R.J. |